(19) Europäisches Patentamt
European Patent Office
Office européen des brevets

(11) **EP 2 650 517 A1**

(12) **EUROPEAN PATENT APPLICATION**

(43) Date of publication:
**16.10.2013 Bulletin 2013/42**

(51) Int Cl.:
*F02D 41/20* (2006.01)    *F02D 41/22* (2006.01)
*G01R 31/06* (2006.01)    *H01F 7/18* (2006.01)

(21) Application number: **12305422.3**

(22) Date of filing: **11.04.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **TI Automotive Fuel Systems SAS**
**51000 Châlons-en-Champagne (FR)**

(72) Inventor: **Fromont, Jean-Sébastien**
**51520 SARRY (FR)**

(74) Representative: **Regimbeau**
**20, rue de Chazelles**
**75847 Paris Cedex 17 (FR)**

(54) **Method for monitoring a fluid injection system and system thereof**

(57)    A method for monitoring a fluid injection system is presented, in a system comprising:
- a fluid dosing pump, activated by a coil, and
- an electronic module, adapted to feed the coil with a driving voltage.
     The method comprises monitoring the evolution of current ($I_p$) flowing through the coil and the evolution of the time derivative (dI/dt) of said current ($I_p$), wherein monitoring the evolution of the current time derivative comprises monitoring two successive zero crossings of the time derivative (dIt) of the current flowing through the coil.

Figure 3c

**Description**

FIELD OF THE INVENTION

The invention relates to the field of fluid injection systems, and methods for monitoring such systems.

This invention applies to any injection system as for example:

- fuel additive injection for diesel particulate filter application,
- fluid injection in the exhaust of motor vehicle for exhaust after treatment (urea for SCR, diesel for diesel particulate filter regeneration, Ethanol for SCR,....) or
- any fluid injection system based with a solenoid driven pump.

BACKGROUND ART

Fluid injection systems generally comprise:

- a fluid tank, for instance an additive tank for a fuel additive injection system,
- a dosing pump, in the form of a piston pump activated by a coil,
- a fluid feeding hose, in fluid communication with the fluid tank,
- an injection check valve, terminating said hose, for delivering said fluid (for instance for inserting said additive into a fuel tank), and
- an electronic controller, feeding the coil with a control voltage, in order to activate the pump and deliver said fluid.

The dosing pumps of such fluid injection systems can encounter diverse operative modes, such as normal operation with fluid, or abnormal operations.

Abnormal operations comprise pumping air instead of liquid, which can happen on system priming, or operation with hose leakage or disconnection, stuck check valve, or mechanically blocked pump.

On current additive injection systems with a piston pump driven by a coil, there is no easy way to detect hydraulic failures or abnormal operation modes as previously described.

There exist solutions for diagnosing such systems based on external sensor such as flow rate sensors, but having recourse to such sensors and installing them in these systems generate a high additional cost.

Other techniques of monitoring fluid injection systems are taught, for instance in documents US 5, 808, 471, US 5, 796, 261 and US6, 307, 376, implementing measurement of current flowing through the coil in order to monitor the operation of the coil.

However, these documents do not allow distinguishing the various abnormal operations a pump can encounter.

SUMMARY OF THE INVENTION

Thus, one object of the present invention is to provide a new technology for assessing various operative modes of a coil piston pump.

Another object of the invention is to provide a low cost technology that is easy to implement.

According to the invention, a method for monitoring a fluid injection system is providing. This method is carried out in a system comprising

- a fluid dosing pump, activated by a coil, and
- an electronic module, adapted to feed the coil with a driving voltage,

the method comprising monitoring the evolution of current flowing through the coil and the evolution of the time derivative of said current,

said method being **characterized in that** it comprises monitoring two successive zero crossings of the time derivative of the current flowing through the coil.

In some embodiments, the method can comprise:

- initializing driving of the pump, said initializing comprising starting feeding the coil with a driving voltage and initializing a time of monitoring,
- monitoring a first zero crossing of the time derivative of the current flowing through the coil, and
- monitoring a second zero crossing of said time derivative, and
- determining a normal or abnormal operating mode of said pump.

According to other embodiments, the method can comprise the following features:

- no first zero crossing happens, and a blocking of the pump or clogging of the system is detected,
- a first zero crossing is detected, and the step of monitoring a second zero crossing comprises detecting a time of second zero crossing of said time derivative,
- no second zero crossing happens before a predetermined time out for second zero crossing detection, and an abnormally high output fluid pressure is detected,
- the method further comprises detecting a minimum value of the time derivative of the current flowing through the coil before said second zero crossing,
- said minimum value is compared to a predetermined minimum value, and, if the detected minimum value is below said predetermined minimum value, a dry functioning of the pump is detected,
- the method further comprises comparing the time of second zero crossing of said time derivative with predetermined minimum and maximum times for second zero crossing,
- the time of second zero crossing is below the minimum time for second zero crossing, a leakage or a missing check valve is detected,
- the time of second zero crossing is comprised between the minimum and maximum times for second zero crossing, and the detected minimum value is superior to the predetermined minimum value, and the system is considered flawless,
- the method further comprises a step of calibration of the system wherein a pump resistance at room temperature is monitored and stored, and prior to the monitoring steps, a step of initializing the pump, said step comprising:

    o measuring the pump resistance,
    o deducing a pump temperature from the pump resistance, and,
    o setting detection thresholds values according to the pump temperature.

According to the invention a fluid injection system is provided, comprising:

- a fluid tank,
- a hose, in fluid cooperation with said tank and comprising an injection check valve,
- a fluid dosing pump, adapted to pump fluid from said tank into said hose,
- a coil, adapted to activate said pump when fed with a voltage, and
- an electronic module, adapted to feed said pump with a control voltage, said fluid injection system being **characterized in that** the electronic module comprises a time derivative monitor of the current flowing through the coil, and in that the electronic module is further adapted to implement the method according to any one of the preceding claims.

The fluid injection system according to the invention can also comprises one or more of these additional features:

- the monitor comprises a current differentiator having an output tension proportional to the time derivative of the current flowing through the coil, thereby enabling the monitoring of said time derivative.
- the monitor comprises a signal processing module.

BRIEF DESCRIPTION OF THE DRAWINGS

The features and advantages of the invention will be apparent from the following more detailed description of certain embodiments of the invention and as illustrated in the accompanying drawings, in which:

- Figure 1 shows a fluid injection system according to the invention,
- Figure 2 shows an example of electrical architecture of an electronic module of a fluid injection system according to the invention
- Figures 3a, 3b, and 3c are curves showing piston position evolution and current profiles during pump actuation in normal operation,
- Figures 4a and 4b are curves showing piston position evolution and current profiles during pump actuation when a check valve is missing in the system or there is a leakage after pump outlet,
- Figures 5a and 5b are curves showing piston position evolution and current profiles during pump actuation with air pumping instead of liquid,
- Figures 6a and 6b are curves showing piston position evolution and current profiles during pump actuation with abnormally high liquid pressure,

- Figure 7 is a curve showing current profiles during pump actuation with a clogged injection system or a mechanically blocked pump,
- Figures 8a and 8b are curves showing comparative current profiles during pump actuation with different operating conditions.
- Figures 9a, 9b, 9c and 9d illustrate the monitoring algorithm implemented in the method according to the invention.

DETAILED DESCRIPTION OF A PREFERRED EMBODIMENT OF THE INVENTION

_Description of a fluid injection system_

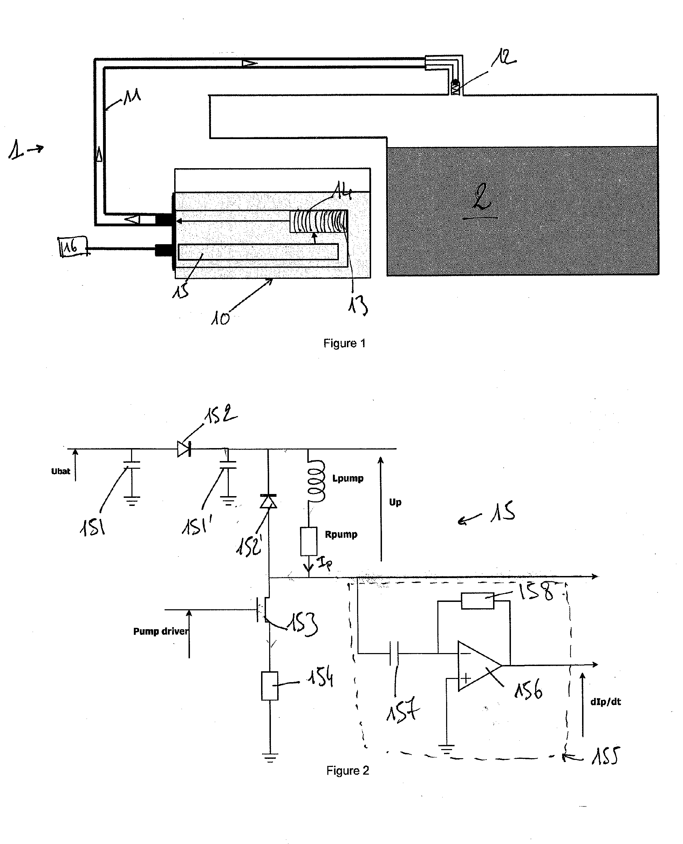

With reference to figure 1, a fluid injection system 1 is shown. This system can be a fuel additive injection system, for injecting an additive into a fuel tank of a vehicle engine. Such additive most of the time comprises urea, used for reducing NOx pollutants in exhaust gases from combustion.

This system 1 comprises a fluid tank 10, such as an additive tank, a feed hose 11, in fluid communication with said tank 10, and terminated by an injection check valve 12. This valve 12 is in fluid communication with for instance a fuel tank 2.

The system 1 further comprises a dosing pump 13, said pump being a piston pump 13 activated by a coil 14. An electronic module 15 feeds the coil 14 with a voltage, and monitors current flowing through the coil 14. This electronic module 15 is itself connected to a power supply 16, which can be a battery of a car.

In normal operation, the electronic module drives the dosing pump 13 with a control voltage signal. When voltage rises, the coil is energized and the piston is attracted in its cylinder (not shown), compressing a return spring (not shown). During this motion, fluid is ejected through an output of the pump, and then through the outlet check valve 12.

Then, when voltage drops, the spring pushes the piston back to its initial position and fluid is sucked from the pump inlet.

In an opposite operative way, when voltage rises and the piston moves in its cylinder to compress a return spring, fluid can be sucked from the pump inlet, and when voltage drops, the spring pushes the piston back to its initial position and fluid is ejected through an output of the pump.

In accordance with the invention, the electronic controller is also able to monitor current profile through the coil 14 and its time derivative. This is enabled by an electrical architecture comprising a differentiator allowing monitoring of the current time derivative through the coil.

An exemplary electrical architecture is represented on figure 2. The coil is represented as an inductance $L_{pump}$ and a resistance $R_{pump}$, that are fed with a DC voltage $U_{bat}$ from a power supply (not shown), typically the battery of a car.

First and second filtering capacitors 151 and 151' are connected in parallel with the power supply (not shown) delivering the power voltage $U_{bat}$, and linked to the ground, a first diode 152 being inserted in series between the capacitors and allowing the current to flow from the power supply to the pump. This first diode protects the power supply from discharges that could come from the pump and protects the electronic module from reverse polarization.

The inductance and resistance of the pump, as well as a second diode 152', are mounted in parallel with the output of the second capacitor 151'. The second diode is eliminating flyback (freewheel diode).

A pump driver is connected to the pump via a transistor 153. A resistor 154 links the transistor to the ground. The transistor is also connected to the input of the second diode and the output of the pump. The transistor works as a switch to drive the operation of the pump. When closed, the current from the pump flows to the resistor 154 and then to the ground. When open, the current from the pump flows back through the second diode 152'. Thus, successively closing and opening the transistor 153 corresponds to successively switching on and off the pump.

Last, a means 155 for monitoring the current time derivative dIp/dt flowing through the coil $L_{pump}$ is provided. Said means can be discrete electronic components or a signal processing module.

In figure 2, said means comprises an operational amplifier 156 mounted as an inverting differentiator, i.e. having a "+" input connected to the ground, a "-" input comprising a capacitance 157, said "-" input being connected to the output of the pump, and the output of the operational amplifier being connected to the "-" input via a resistor 158.

Thus the differentiator measures an input tension proportional to the current $I_p$ flowing through the coil and outputs a tension proportional to the time derivative of said current.

_Correlation between current profile through the coil and piston motion_

The current profile through the coil and its derivative are directly linked to the inductance evolution of the coil driven pump during piston motion. It can be noticed thanks to the electrical equations below:

$$U = Ri + \frac{d\lambda}{dt}$$

With $\lambda = Li$, i.e. the magnetic flux through the coil, U being the driving voltage, R being the coil resistance, L the coil inductance and i the current flowing through the coil. The resistance R varies with a room temperature:

$$R(T) = T(T0) + \alpha(T - T0)$$

With $\alpha$ being a thermal coefficient, T the room temperature, and T0 the room temperature during an initial calibration step (see below).
Then

$$U = Ri + L\frac{di}{dt} + i\frac{dL}{dt} = Ri + L\frac{di}{dt} + i\frac{dL}{dx}\frac{dx}{dt} + i\frac{dL}{di}\frac{di}{dt}$$

Where x is the instantaneous position of the moving piston.
Then

$$\frac{di}{dt} = \frac{U - i(R + \frac{dL}{dx}\frac{dx}{dt})}{L + i\frac{dL}{di}}$$

In addition, the piston motion (position, velocity and acceleration), is characterized by the following set of equations:

$$m\frac{d^2x}{dt^2} = F_m(x, i) - F_{spring}(x) - F_{frs} - F_{frd} - \Delta F_P$$

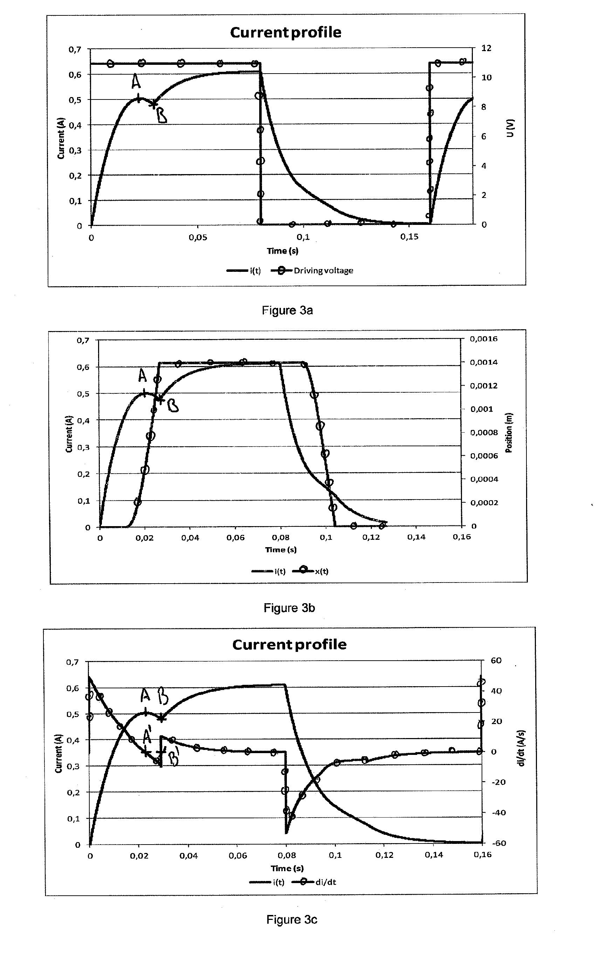

Where $F_{frs}$ is static friction, $F_{frd}$ is dynamic friction, proportional to the velocity of the piston, and $\Delta F_P$ are pressure effects which depend on the velocity of the piston, on the check valve, hose, and other parameters of the system.
Therefore, the monitoring of the current flowing through the coil and its time derivative gives a lot of information on the behavior of the pump.
For instance, figures 3a-3c show the correlation between the motion of the piston and the current flowing through the coil and its time derivative in normal operation. Said normal operation comprises the pump pumping liquid and the system comprising a check valve 12 terminating the hose 11. The values of the different curves are only illustrative examples; they do not limit the scope of the invention.
With reference to figure 3a, voltage square pulses are applied to the coil by the pump driver, the voltage values being indicated on the right-hand axis. Each pulse induces a current elevation in said coil, the current value being indicated on the left-hand axis.
The current increase in the coil induces a corresponding motion of the piston inside the pump, represented in figure 3b, the position of the piston being indicated on the right-hand axis. The current deflection points A and B on figures 3a to 3c are due to the piston motion in its cylinder, which impacts the inductance value of the coil.
Indeed, as the piston starts moving inside the core, the current time derivative decreases, until first crossing 0, i.e. the current stops increasing at point A and begins decreasing. The current and corresponding time derivative reach respective minimum values, on point B and B' when the velocity of the piston is maximum. Once the piston has reached its maximum position, the current value increases again, along with the current time derivative which crosses zero a second time, until the establishment of the current in the coil is complete.
We can notice on this nominal behavior example that current derivative at end of the first piston motion (at about 0,026 s) ; being the minimum value of the current is close to -7 A/s and piston stroke lasts about 14 ms roughly (between 0.012 s and 0.026 s).

On figure 3c, the current time derivative is represented, which values are indicated on the right-hand axis. The first and second zero crossing A' and B' are shown in this figure.

This normal behavior of current and current time derivative is compared to the same in abnormal operation.

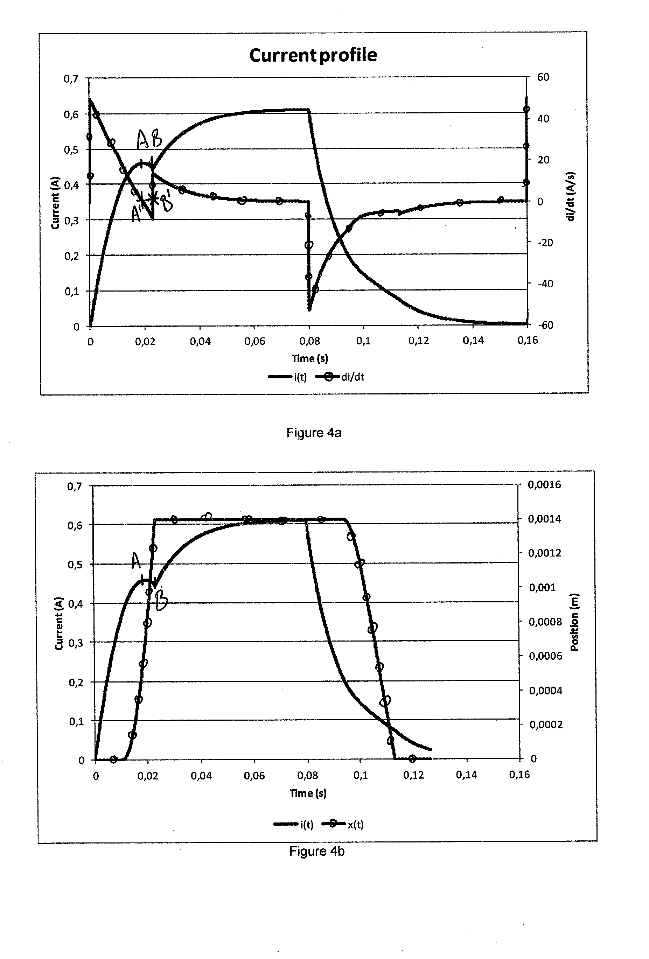

With reference to figures 4a and 4b, current and current time derivative curves are shown, in an operative situation in which the pump is operated with liquid, and either the check valve 12 is missing, or there is a leakage after the pump outlet.

It appears, particularly in figure 4a, that the piston motion is quicker than in normal operation (about 0.1 s), since the output pressure of the pump is lower, and therefore the current deflection points A and B induced by this motion occur sooner than in normal operation. As a consequence, the current time derivative zero crossing points A' and B' happen sooner than the same points in normal operation.

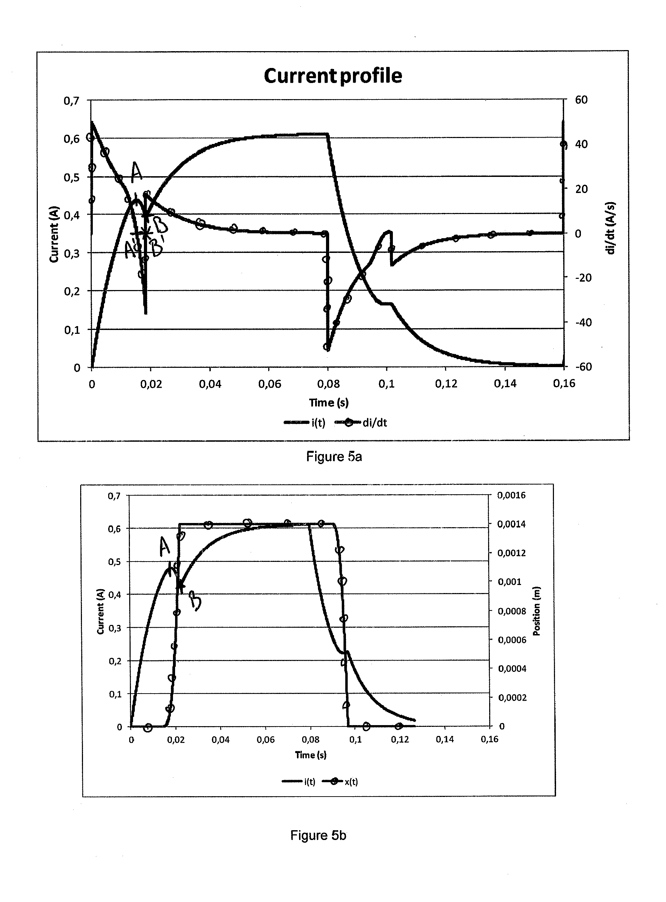

With reference to figures 5a and 5b, the same curves are illustrated in an operative situation in which the pump is pumping air, for instance during system priming. This is called "dry condition", or "dry operation".

When functioning in dry condition, the piston motion is much quicker than with liquid (about 7 ms instead of 14 ms), and the current time derivative reaches a far inferior to that of normal operation, for instance of -32 A/s on the point B' at end of piston motion (instead of -7 A/s). The main difference between current time derivative with air and with liquid is due to dynamic friction on the piston that is much lower with air.

In addition, during motion back to rest position caused by the return spring on the piston, the current derivative becomes positive, and then suddenly drops again. This is due to the end of motion of the piston, and a sudden nil velocity.

The operational mode of the pump can then be distinguished by evaluating the current time derivative during "On" phase of the power supply, i.e. when a control voltage is applied to the coil. In addition, for confirmation purpose, the "jump" in current time derivative during "off" phase (when the piston gets back to rest position) can be evaluated.

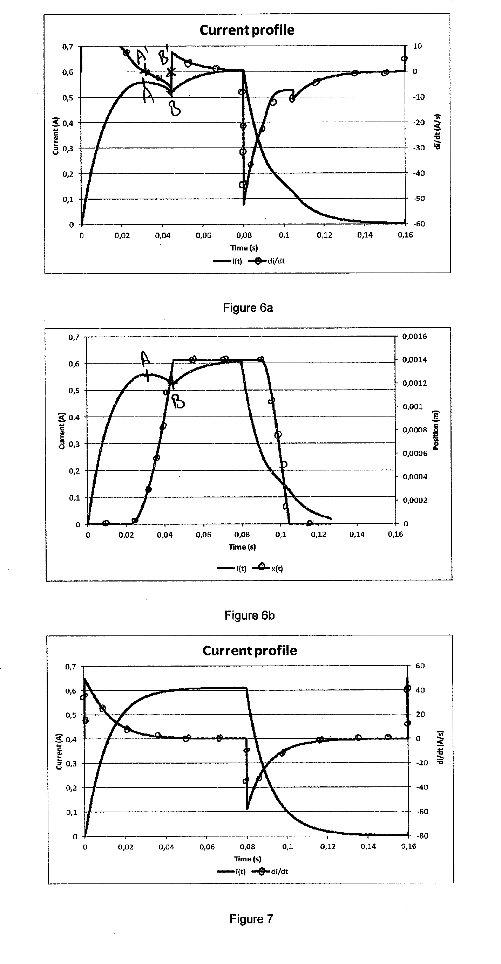

With reference to figures 6a and 6b, the same curves are illustrated in an operative mode in which the pump is pumping liquid, but there is an abnormally high pressure output fluid pressure, for instance in the check valve pressure.

In this situation, the start of piston motion is obtained at a higher current than with nominal check valve. The current time derivative during piston motion stays negative, i.e. the time elapsed between points A' and B' lasts 15 ms instead of 5 ms in normal condition.

With reference to figure 7, curves of current and current time derivative are illustrated in an operative mode in which the system is clogged (at the pump outlet, or at the check valve for instance). In that case, the current deflection points A and B do not appear since the piston does not achieve its complete motion through the cylinder and thus do not alter the coil impedance.

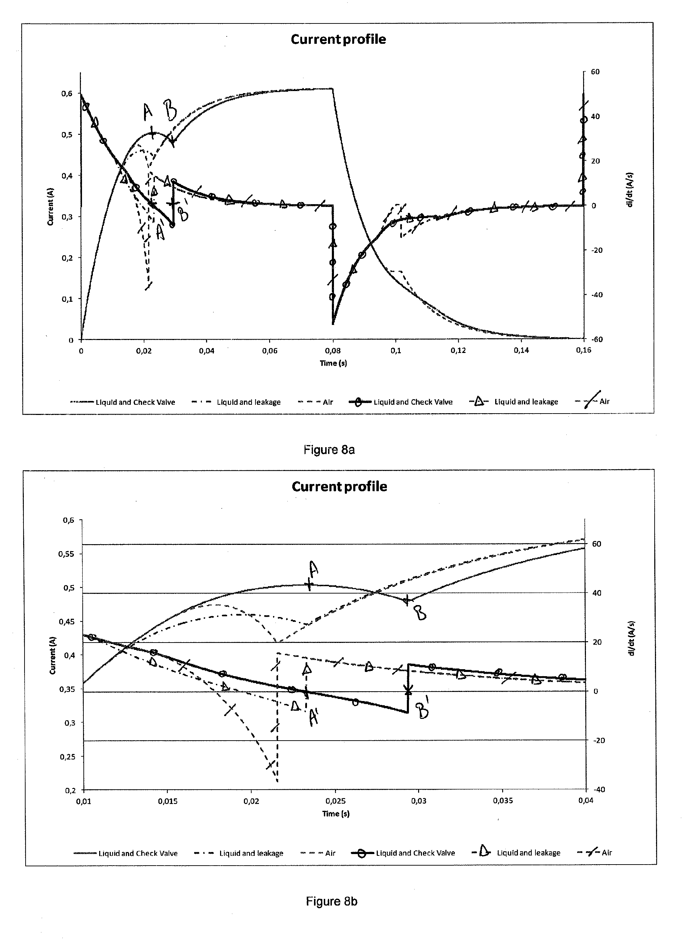

Summary current profiles are illustrated in figures 8a, with a focus in figure 8b on the zone of current deflection points (zone centered on A, A' and B, B'). For the sake of clarity, the deflection points A, B, A', B' are only represented for the curve of normal operation. In these figures, the three first curves show the current profile, and the three last curves, with symbols, are current time derivative profiles.

It clearly appears that in case there is a leakage in the system, said leakage can be easily determined by monitoring the time at which the second zero crossing of the current time derivative happens. Also, a dry operation can be detected if the minimum value of the current time derivative is below a predetermined threshold, as this minimum value is much beneath the minimum value of this derivative in normal conditions.

*Preferred embodiment of implementation of the method.*

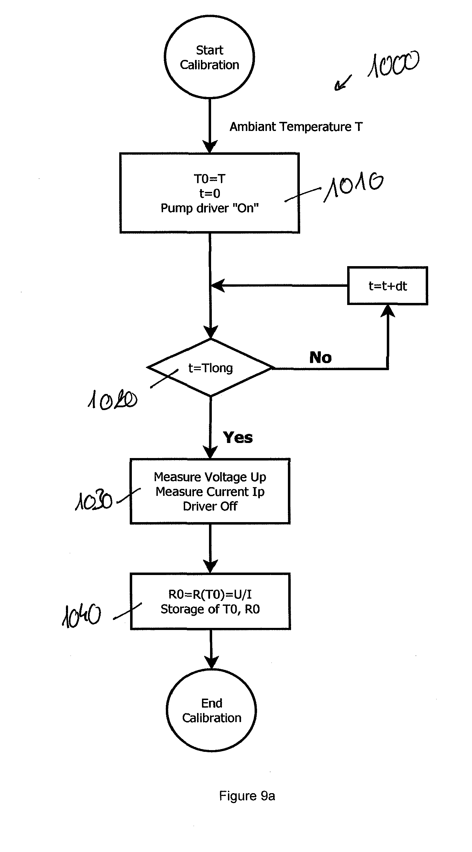

During assembly of the fluid injection system, a first step of calibration of the system 1000 is carried out, with reference to figure 9a. During this calibration, a room temperature is measured by the electronic module or transmitted by external means. Afterwards, the electronic module drives the power supply to deliver one long voltage $U_{bat}$ pulse and measures the current flowing through the coil in steady state.

More precisely, this step of calibration comprises a step 1010 of setting a recorded temperature T0 at t=0 as equal to the ambient temperature T, initializing a timer t equal to 0 s, and switching on the pump driver.

Then, a step 1020 consists in checking that the elapsed time t equals the predetermined duration $T_{long}$ of the power signal for calibration, and if not so, waiting until t reaches $T_{long}$.

Then, a step 1030 consists in measuring the pump voltage Up and the pump current Ip, and switching off the pump driver.

Then, a step 1040 consists in setting the value of the pump resistance R0 as the resistance at the temperature T0, being equal to Up/Ip, and storing T0 and R0 in a memory of the electronic circuit (not shown).

Afterwards, and before each step of driving the dosing pump for injection of fluid, an initialization step is carried out, during which the electronic module drives the pump over one long pulse the same way as during calibration process.

The aim is to estimate pump resistance due to temperature change. More precisely the resistance of the pump is given by the equation $R(T) = R(T0) + \alpha(T - T0)$. Measuring the resistance of the pump R(T), given the resistance R(T0) allows measuring the current temperature (T) in the pump, with a better precision than if the temperature was measured directly by the electronic module.

Then, given the current temperature T, the electronic module chooses values of detection thresholds described hereinafter (TZC2MIN, TZC2MAX, DIMIND), these thresholds being sensitive to temperature changes, in an embedded look- up table comprising different values of these thresholds in function of the temperature.

After the initialization process, the monitoring and flaw diagnostic method relies on:

- Detection of a first current time derivative zero crossing, indicating a piston motion started,
- Evaluating a minimum value of current time derivative, in order to discriminate a dry or liquid operative mode,
- Detecting a second zero-crossing of current derivative, in order to detect the end of piston motion, and
- Evaluating the instant of the second zero-crossing, to discriminate between the presence of check valve and a leakage or an absence of said check valve.

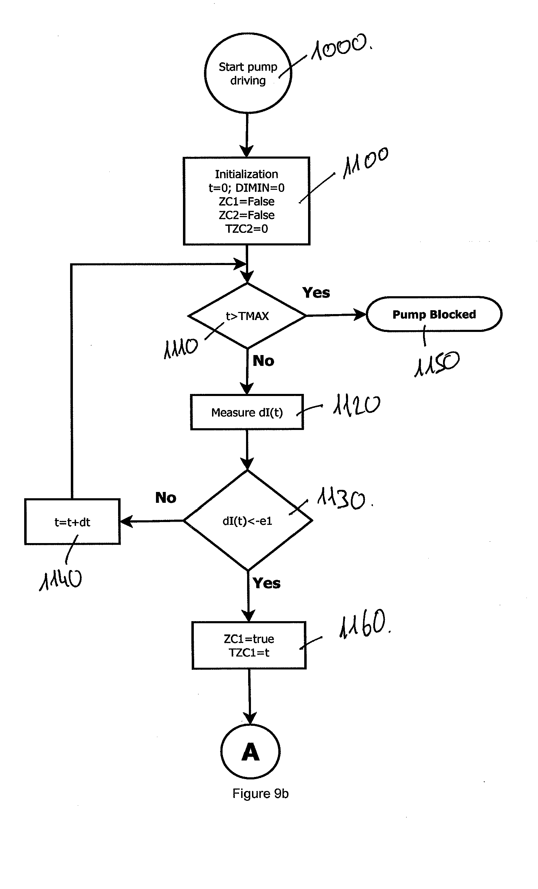

This method is detailed with reference to figures 9b to 9d.

In figure 9b, step 1000 consists in starting the pump driver.

Step 1100 consists in starting the monitoring of the pump, by:

- initializing a time recording t=0,
- setting a minimum value of the current time derivative DIMIN to 0 A/s,
- setting two flags ZC1 and ZC2, indicating respectively first and second zero crossing of current time derivative, as "false", meaning said derivative as not crossed zero yet, and
- setting a time TZC2 of second zero crossing of time derivative to 0 s.

A predetermined time TMAX is set, corresponding to the time out for zero crossing of the current time derivative. This time is determined by recording several times of first and second zero crossing detection in normal operation. A step 1110 consists in checking if the elapsed time t exceeds this time TMAX.

If not, the current time derivative dI(t) is measured at time t during step 1120, and it is compared during step 1130 to a threshold -e1 (e1 being a positive value), corresponding to a safety margin for noise disturbance. If $dI(t) < -e1$, the derivative is considered for sure to be negative.

If dI(t) is not inferior to -e1, then the recording time t is incremented at step 1140 and steps 1110 to 1130 are iterated until the current time derivative is negative, unless the time t exceeds time TMAX at which the derivative is supposed to have crossed zero. In that case, the pump is determined to be blocked at step 1150, and the process terminates.

Conversely, if before the time TMAX, the current time derivative reaches a value below- e1, then it is considered that the derivative has first crossed zero. Thus, at step 1160, the time t at which said value- e1 is reached is registered as the time TZC1 of the first zero crossing of the current time derivative. The flag ZC1 of first crossing of zero is set equal to "true".

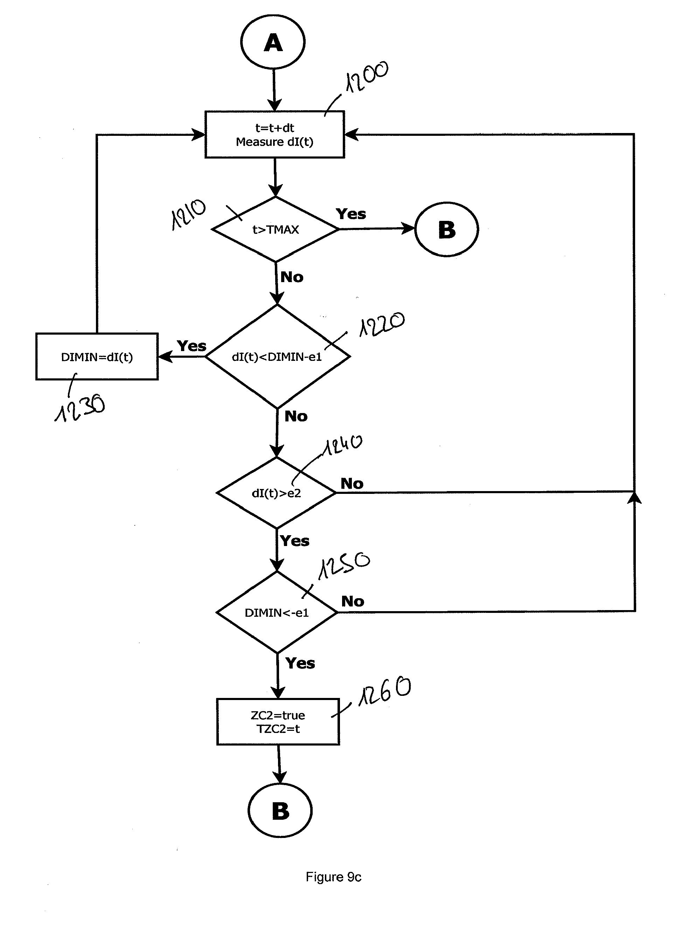

Then, with reference to figure 9c, a step 1200 of incrementing time t and measuring the current time derivative at this time t is implemented.

If has not exceeded TMAX (comparison step 1210), then, during step 1220 the current time derivative dI(t) is compared to DIMIN - e1. As DIMIN has initially been set to 0, this comparison is the same as step 1150, and the result is positive.

DIMIN is then set to the value of dI(t) at step 1230, and steps 1200 to 1220 are iterated until dI(t) is not inferior to DIMIN-e1 anymore. Thus, these iterations aim at detecting the minimum value reached by the current time derivative after its first zero crossing.

At step 1220, after the various iterations, dI(t) not being inferior to DIMIN-e1 means that the current time derivative has stopped decreasing. At step 1240, dI(t) is compared to a second positive threshold value e2, in order to detect that the current time derivative has increased until being positive again. If not, steps 1200 to 1220 are iterated until dI(t) exceeds e2.

When dI(t) exceeds e2, the stored minimum value DIMIN of the current time derivative is compared at step 1250 with -e1, in order to determine for sure that, when dI(t) reached DIMIN, it was negative indeed. In that case, the transition from DIMIN to a value exceeding e2 indicates that the current time derivative has crossed zero a second time.

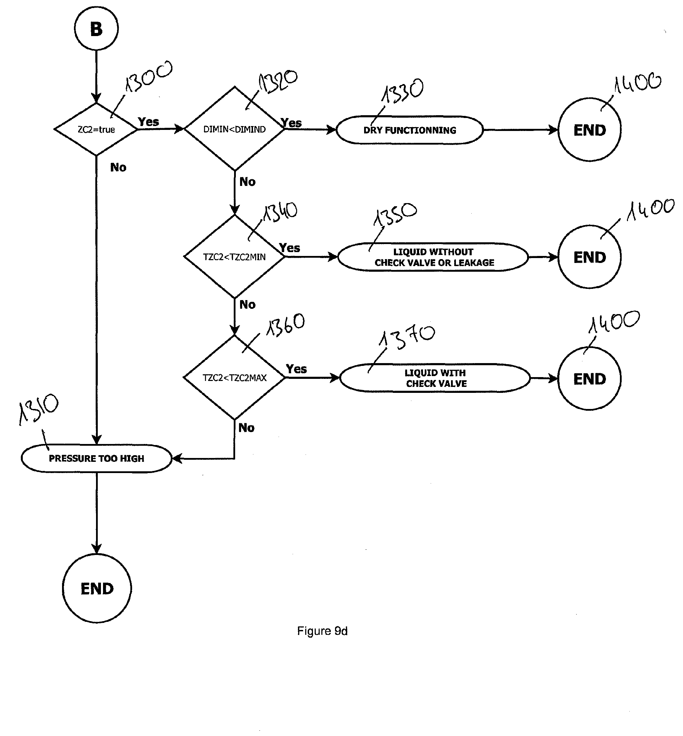

Then, at step 1260, the flag ZC2 indicating that a second zero crossing has occurred is set equal to "true", and the time at which all steps 1200 to 1250 have been overcome is registered as the time TZC2 at which the second zero crossing happened. The process then continues on step 1300 in figure 9d.

However, if after the various increments of the monitoring time t, the latter becomes superior to TMAX (step 1210), the process directly continues on step 1300 in figure 9d. Step 1300 consists in checking the flag ZC2.

If ZC2 is false, which is the case it this step is carried out immediately after step 1210 of checking the monitoring time t, it means that after the first zero crossing of the current time derivative, no second zero crossing has been detected before a time equal to TMAX has elapsed.

TMAX is preferably defined as a time superior to the normal time of happening of the zero crossings, like for instance TMAX = 0.04 s on figure 6a, for detection of a high fluid output pressure. t being superior to TMAX happens when there is an abnormally high output pressure of the fluid, for instance in the check valve.

Thus, if t>TMAX; In that case, an abnormally high output pressure of the fluid is detected on step 1310 and the process is terminated on step 1400.

Conversely, if t<TMAX (like after step 1260) ; a step 1320 occurs of comparing the minimum value of the current time derivative DIMIN before the second zero crossing, and stored at step 1230, to a predetermined minimum value of the current time derivative DIMIND, said value being a threshold on DIMIN for detection of dry functioning of the pump, as represented in figure 5a.

Thus, if DIMIN is inferior to DIMIND, a dry functioning of the pump is detected at step 1330, and the process then terminates on step 1400.

Conversely, if DIMIN is superior to DIMIND, the process continues to step 1340. In this step, the time TZC2 at which the current time derivative crosses zero a second time is compared to a predetermined minimum time TZC2MIN at which this second zero crossing should have happened. This minimum time is set at a value allowing the detection of a leakage or an absence of a check valve in the system. Indeed, with reference to figure 4a, in that case the second zero crossing happens earlier than in normal operation.

Thus, if TZC2 is inferior to TZC2MIN, a leakage or the absence of a check valve is detected on step 1350, and the process terminates at step 1400.

Conversely, if TZC2 is found superior to TZC2MIN, the process continues on step 1360. This step consists in comparing the value TZC2 to a predetermined maximum time TZC2MAX at which the second zero crossing of the current time derivative should have happened.

With reference again to figure 6a, depending on the values of TMAX and TZC2MAX, a monitoring time t inferior to TMAX but superior to TZC2MAX can also be indicative of an operative mode in which the liquid output pressure is too high. Thus, if TZC2 is superior to TZC2MAX, an abnormally high fluid output pressure is detected in step 1310, and the process terminates at step 1400.

Conversely, if TZC2 is inferior to TZC2MAX, then no flaw has been detected, the system is considered to run in normal operative mode at step 1370, and the process terminates at step 1400.

TZC2MIN, TZC2MAX, and DIMIND are embedded in the electronic module as temperature- dependent look up tables, hence the measure of temperature in the calibration step.

In a nutshell, the method according to the invention provides an easy and cost-efficient way to discriminate various operating states of a fluid injection system, comprising a normal operating mode, a dry mode, a clogged system, an abnormally high pressure in the system, or a functioning mode without check valve or with a leakage after the pump.

**Claims**

1.  A method for monitoring a fluid injection system (1), said system (1) comprising:

    - a fluid dosing pump (13), activated by a coil (14), and
    - an electronic module (15), adapted to feed the coil (14) with a driving voltage,
    the method comprising monitoring the evolution of current ($I_p$) flowing through the coil (14) and the evolution of the time derivative (dlt) of said current ($I_p$),
    said method being **characterized in that** it comprises monitoring two successive zero crossings of the time derivative (dlt) of the current flowing through the coil (14).

2.  A method according to claim 1, characterized it comprises:

    - starting driving of the pump (13), said starting comprising beginning feeding the coil (14) with a driving voltage and initializing a time (t) of monitoring,
    - monitoring a first zero crossing (ZC1) of the time derivative of the current flowing through the coil, and
    - monitoring a second zero crossing (ZC2) of said time derivative, and
    - determining a normal or abnormal operating mode of said pump.

3.  A method according to claim 2, wherein no first zero crossing (ZC1) happens, and a blocking of the pump or clogging of the system is detected.

4.  A method according to claim 2, wherein a first zero crossing (ZC1) is detected, and the step of monitoring a second zero crossing (ZC2) comprises detecting a time of second zero crossing (TZC2) of said time derivative.

5. A method according to claim 4, wherein no second zero crossing happens before a predetermined time out (TMAX) for second zero crossing detection, and an abnormally high output fluid pressure is detected.

6. A method according to claim 4, further comprising monitoring the time derivative of the current flowing through the coil reaching a minimum value (DIMIN) before said second zero crossing.

7. A method according to claim 6, wherein said minimum value (DIMIN) is compared to a predetermined minimum value (DIMIND), and, if the detected minimum value (DIMIN) is below said predetermined minimum value (DIMIND), a dry functioning of the pump is detected.

8. A method according to any of claims 4 to 7, comprising comparing the time of second zero crossing (TZC2) of said time derivative with predetermined minimum (TZC2MIN) and maximum times (TZC2MAX) for second zero crossing.

9. A method according to claim 8, wherein, if the time of second zero crossing (TZC2) is below the minimum time (TZC2MIN) for second zero crossing, a leakage or a missing check valve is detected.

10. A method according to claim 8, wherein the time of second zero crossing (TZC2) is comprised between the minimum (TZC2MIN) and maximum (TZC2MAX) times for second zero crossing, and the detected minimum value (DIMIN) is superior to the predetermined minimum value, and the system is considered flawless.

11. A method according to any of the preceding claims, further comprising:

    - a step of calibration of the system wherein a pump resistance at room temperature is monitored and stored, and
    - prior to the monitoring steps, a step of initializing the pump, said step comprising:

        o measuring the pump resistance,
        o deducing a pump temperature from the pump resistance, and,
        o setting detection thresholds values according to the pump temperature.

12. A fluid injection system (1), comprising:

    - a fluid tank (10),
    - a hose (11), in fluid cooperation with said tank and comprising an injection check valve (12),
    - a fluid dosing pump (13), adapted to pump fluid from said tank into said hose,
    - a coil (14), adapted to activate said pump when fed with a voltage, and
    - an electronic module (15), adapted to feed said pump with a control voltage, said fluid injection system being **characterized in that** the electronic module (15) comprises a time derivative monitor (155) of the current flowing through the coil, and **in that** the electronic module is further adapted to implement the method according to any one of the preceding claims.

13. A fluid injection system (1) according to claim 12, wherein the monitor (155) comprises a current differentiator having an output tension proportional to the time derivative of the current flowing through the coil, thereby enabling the monitoring of said time derivative.

14. A fluid injection system (1) according to claim 12, wherein the monitor (155) comprises a signal processing module.

Figure 1

Figure 2

Figure 3a

Figure 3b

Figure 3c

Figure 4a

Figure 4b

## Current profile

Figure 5a

Figure 5b

Figure 6a

Figure 6b

Figure 7

Figure 8a

Figure 8b

Figure 9a

Figure 9b

Figure 9c

Figure 9d

Europäisches
Patentamt

European
Patent Office

Office européen
des brevets

## EUROPEAN SEARCH REPORT

Application Number

EP 12 30 5422

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/148831 A1 (KEKEDJIAN HARRY [CA] ET AL) 26 June 2008 (2008-06-26) <br> * abstract * <br> * paragraphs [0007], [0008] * <br> * paragraph [0032] - paragraph [0038] * <br> * figures 3a,3b,4,6a,6b * <br> ----- | 1-14 | INV. <br> F02D41/20 <br> F02D41/22 <br> G01R31/06 <br> H01F7/18 |
| X | DE 195 24 755 A1 (BENDRICH HORST [DE]) 9 January 1997 (1997-01-09) <br> * abstract * <br> * column 1, line 43 - column 2, line 25 * <br> * figures 1a,b,c, 2 * <br> ----- | 1-4, 11-14 | |
| A | DE 41 22 348 A1 (JATCO CORP [JP]) 23 January 1992 (1992-01-23) <br> * abstract * <br> * column 1, line 25 - line 42 * <br> * page 1, line 56 - page 2, line 55 * <br> * figures 2a,2b,3a,3b,4 * <br> ----- | 1-14 | |
| A | DE 10 2009 045307 A1 (ROBERT BOSCH GMBH) 7 April 2011 (2011-04-07) <br> * abstract * <br> * paragraph [0003] * <br> * paragraphs [0005] - [0007] * <br> * paragraph [0012] * <br> * paragraphs [0036] - [0039] * <br> * figure 3 * <br> ----- | 1-14 | TECHNICAL FIELDS SEARCHED (IPC) <br><br> F02D <br> G01R <br> H01F |
| A | DE 101 29 153 A1 (FESTO AG & CO) 9 January 2003 (2003-01-09) <br> * paragraph [0012] * <br> * paragraph [0028] - paragraph [0031] * <br> * figures 4,5 * <br> ----- <br> -/-- | 1,12 | |

The present search report has been drawn up for all claims

| Place of search | Date of completion of the search | Examiner |
|---|---|---|
| Munich | 5 September 2012 | Wettemann, Mark |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                   

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 12 30 5422

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 42 42 432 A1 (EBERN FAHRZEUGTECH GMBH [DE]) 23 June 1994 (1994-06-23)<br>* abstract *<br>* column 1, line 41 - line 57 *<br>* claim 4 *<br>----- | 1,12 | |
| A | DE 38 07 278 A1 (TECH UEBERWACHUNGS VEREIN RHEI [DE]) 14 September 1989 (1989-09-14)<br>* abstract *<br>* column 1, line 28 - column 2, line 19 *<br>* column 5, line 39 - line 47 *<br>----- | 1,12 | |

| | | | |
|---|---|---|---|
| | | | TECHNICAL FIELDS SEARCHED (IPC) |

The present search report has been drawn up for all claims

| Place of search | Date of completion of the search | Examiner |
|---|---|---|
| Munich | 5 September 2012 | Wettemann, Mark |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..........................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 12 30 5422

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2012

| Patent document cited in search report | | Publication date | Patent family member(s) | | Publication date |
|---|---|---|---|---|---|
| US 2008148831 | A1 | 26-06-2008 | NONE | | |
| DE 19524755 | A1 | 09-01-1997 | NONE | | |
| DE 4122348 | A1 | 23-01-1992 | DE | 4122348 A1 | 23-01-1992 |
| | | | US | 5153522 A | 06-10-1992 |
| DE 102009045307 | A1 | 07-04-2011 | DE 102009045307 A1 | | 07-04-2011 |
| | | | WO | 2011039044 A1 | 07-04-2011 |
| DE 10129153 | A1 | 09-01-2003 | NONE | | |
| DE 4242432 | A1 | 23-06-1994 | NONE | | |
| DE 3807278 | A1 | 14-09-1989 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5808471 A
- US 5796261 A
- US 6307376 B